# EUROPEAN PATENT SPECIFICATION

(11) **EP 1 986 473 B1**
(45) Date of publication and mention of the grant of the patent: **25.01.2017**
(21) Application number: 08006767.1
(22) Date of filing: 02.04.2008
(51) Int. Cl.: H05B 33/22, H01L 51/50

(54) **ORGANIC ELECTROLUMINESCENT DEVICE**
ORGANISCHE ELEKTROLUMINESZENTE VORRICHTUNG
DISPOSITIF ÉLECTROLUMINESCENT ORGANIQUE

(30) Priority: 03.04.2007 CN 200710065095; 14.11.2007 CN 200710177325
(43) Date of publication of application: 29.10.2008
(73) Proprietor: Tsinghua University, Beijing 100085 (CN); Beijing Visionox Technology Co., Ltd., Haidian District Beijing 100085 (CN); Kunshan Visionox Technology Co., Ltd., Kunshan Jiangsu 215300 (CN)
(72) Inventor: Qiu, Yong, Beijing 100085 (HK); Xie, Jing, Beijing 100085 (HK); Gao, Yudi, Kunshan, Jiangsu Province 215300 (HK); Duan, Lian, Beijing 100085 (HK)
(74) Representative: Regimbeau

(56) References cited:
- EP-A- 1 659 129
- EP-A- 1 727 397
- US-A1- 2006 008 742

## Description

### RELATED APPLICATIONS

This application claims priority to China Patent Application Serial No. 200710065095.5 filed on April 3, 2007 and China Patent Application Serial No. 200710177325.7 filed on November 14, 2007, the contents of which are incorporated herein by reference.

### FIELD OF INVENTION

The present invention relates to an organic electroluminescent device, and particularly relates to an organic electroluminescent device in which at least one of hole injection layer, hole transport layer and electron transport layer is doped with an inorganic inactive material.

### BACKGROUND OF THE INVENTION

An organic electroluminescence flat display has many significant advantages, such as initiative light-emitting, light, thin, good contrast, independence of an angle, low power consumption and the like. In 1963, an organic electroluminescence device was fabricated by Pope et al with an anthracene single crystal. However, the first high efficient organic light-emitting diode (OLED) fabricated by vacuum evaporation was an OLED developed by C. W. Tang et al in 1987, wherein aniline-TPD was used as a hole transport layer (HTL), and a complex of aluminium and 8-hydroxyquinoline-ALQ was used as a light-emitting layer (EML). Its operating voltage was less than 10V, and its luminance was up to 1000 cd/m². The light-emitting wavelength of organic electroluminescence materials developed later could cover the whole range of visible light. This breakthrough development made the field becoming a currently research hotspot. After entering 1990s, organic high molecular optical-electric functional materials entered a new development stage.

The structure of an organic electroluminescent device usually includes: substrate, anode, organic layer and cathode. An organic layer therein includes emitting layer (EML), hole injection layer (HIL) and/or hole transport layer (HTL) between anode and EML, electron transport layer (ETL) and/or electron injection layer (EIL) between EML and cathode, and also hole block layer between EML and ETL, and so on.

The mechanism of an organic electroluminescent device is like this:
When the electric field is on the anode and cathode, hole is injected into EML from anode through HIL and HTL, and electron is injected into EML from cathode through EIL and ETL. The hole and electron recombine and become exciton in EML The exciton emits light from excitated state to ground state.

In the conditional devices of double layer or multilayer, HTL is absolutely necessary, which possess of good ability of charge transport and play a role of hole transport through proper energy level and structure design. However, the ability of hole transport is usually much better than electron transport. The difference of carrier mobility between hole and electron can be up to 10∼1000, which will impact the device on efficiency and lifetime severely. To obtain higher luminous efficiency, it is necessary to balance the hole and electron.

Now, the normally used hole transport materials are aromatic triamine derivatives, such as NPB, TPD and so on. However, the thermal stability of these materials are very poor, for example, the glass transition temperature (Tg) of NPB is 96 deg. C and TPD is only 65 deg. C . As a result of the poor stability, the device has a shorter lifetime.

In order to overcome the above problems, there have been activities, in recent years, to develop organic electroluminescent devices using doping technology in HIL, HTL and ETL.

There have been a report about rubrene doped in HTL by Z. L. Zhang et al. (J. Phys. D: Appl. Phys., 31, 32-35, 1998). The doping of rubrene in HTL can facilitate hole and electron injection at the interface of ITO/HTL and Alq3/HTL because of the lower HOMO (-5.5eV) and higher LUMO (-2.9eV) of rubrene. The doping of rubrene in HTL can improve the device stability due to the reduction of Joule heat in device working and suppression of molecular aggregation and crystallization at interface. But the dopant of rubrene have an unfavorable impact on the device spectra because of the emission of rubrene itself.

As usual, the thickness of HIL must be thick enough to cover the merits on ITO anode surface to improve the quality of ITO surface. It is also important to introduce dopant into HIL to reduce the driven voltage and improve the power consumption. The dopant in HIL is called p-type dopant. The p-type dopant and HIL host will form charge transfer complexes (CT), which can favor hole injection and so reduce voltage and power consumption. F4-TCNQ and oxide of metal, etc., are the most used p-tpye dopants. However, the disadvantages of F4-TCNQ are its volatility to easily pollute the deposition chamber and poor thermal stability, which will unfavor storage and use at high temperature.

US 2006/008742 A1 discloses a process for production of electroluminescent element.

### SUMMARY OF THE INVENTION

According to one aspect of the present invention, there is provided an organic electroluminescent device according to claim 1.

The term of "inorganic inactive material" used herein may refer to an inorganic material that does not emit light and has electrical and chemical stability in an organic electroluminescent device of the present invention under common conditions.

In some embodiments of the present invention, the inorganic inactive material may be doped in the whole host material uniformly, or in the partial or whole host material in a gradient manner, or in at least one zone of the host material. In the case that the inorganic inactive material is doped in zones of the host material, the number of said zones can be 1∼5. In some cases, zones of the host material and zones of the host material doped with the inorganic inactive material may be disposed together alternatively.

In some embodiments of the present invention, the concentration of said inorganic inactive material doped in the host material may be within a range of: 1∼99 wt%, 4 80 wt%, 10∼50 wt%, 30∼40 wt%, for example, may be 4wt%, 10wt%, 30wt%, 40wt%, 50wt% or 80wt%.

In some embodiments of the present invention, the halide, oxide, sulfide, carbide, nitride or carbonate of metal of lanthanide series can be a halide, oxide, sulfide, carbide, nitride or carbonate of neodymium, samarium, praseodymium or holmium.

In some certain embodiments of the present invention, the inorganic inactive material can be selected from BiF₃, BiCl₃, BiBr₃, BiI₃, Bi₂O₃, YbF₃, YbF₂, YbCl₃, YbCl₂, YbBr₃, YbBr₂, Yb₂O₃, Z2(CO₃)₃, LiF, MgF₂, CaF₂, AlF₃, rubidium fluoride, molybdenum oxide, tungsten oxide, titanium oxide, rhenium oxide, tantalum oxide, lithium nitride, and mixtures thereof. In some particular embodiments of the present invention, the inorganic inactive material can be BiF₃ or YbF₃, and the concentration of the inorganic inactive material in the host material can be 30∼40 wt%.

In some other embodiments of the present invention the inorganic inactive material doped in the host material may have a thickness of 10∼200 nm in the HIL, or a thickness of 5∼20 nm in the HTL, or a thickness of 5∼20 nm in the ETL.

According to another aspect of the present invention, there is provided a method for preparing the organic electroluminescent device according to any one of claims 1-17, comprising doping the inorganic inactive material into the host material of at least one of the hole injection layer (HIL) and hole transport layer (HTL). The inorganic inactive material can be doped into the host material by vapor deposition.

Without being limited to any theory, we believe that it will control the concentration of charge carrier and make a better balance between hole and electron by doping of inorganic inactive materials in HIL, HTL and ETL. The balance of hole and electron can lead to effective recombination of carriers and enhance the luminous efficiency. If hole is blocked, the probability of Alq3 cation can be reduced effectively. The injection and transport of electron could be enhanced by the interaction between inactive materials and EIL, ETL materials. The device stability also could be improved by crystallization suppression of organic layers due to higher stability of dopant materials. On the other hand, the film growth mode of organic materials is usually island-like. The doping of inactive material could fill the space of organic host and make the organic film more uniform and smooth. The inactive material is equal to parallel capacitance when the device is put on electric field. This can reduce the resistance of organic layers and enhance the charge concentration and finally improve the driven voltage of devices.

According to certain embodiments of the present invention, the host material of HTL can be aromatic amine derivatives, for example, aromatic diamine, aromatic triamine compound, amine with starburst and spire structure and so on, such as TPD, NPB, m-MTDATA, TCTA and spiro-NPB etc. The host material of HIL can be phthalocyanine and triphenylamine derivatives, such as CuPc, m-MTDATA and TNATA etc.

The following merits may be observed in some embodiments of the present invention:
1. The luminous efficiency could be improved effectively by the better balance between hole and electron, which may from the higher recombination efficiency of charge carrier due to the control of carrier concentration by doping with inorganic inactive materials.
2. The resistance of organic layers could be improved by doping with inorganic inactive materials to enhance conductance of organic layers. This leads to the increase of charge concentration and the increase of driven voltage.
3. The blocking of hole transport by doping could reduce the probability of Alq3 cation and slow the attenuation of device operation.
4. The crystallization of organic materials could be suppressed effectively by doping with higher thermal stable inorganic materials. Then, the stability of organic film could be improved obviously, which is one of the key factors to decide the temperature range and thermal stability of a device.
5. The doping of inorganic inactive materials cannot impact on the device electroluminescent spectra.

### BRIEF DESCRIPTION OF THE DRAWINGS

Now, some embodiments of organic electroluminescent device of the present invention are described with reference to the accompanying drawings in which:

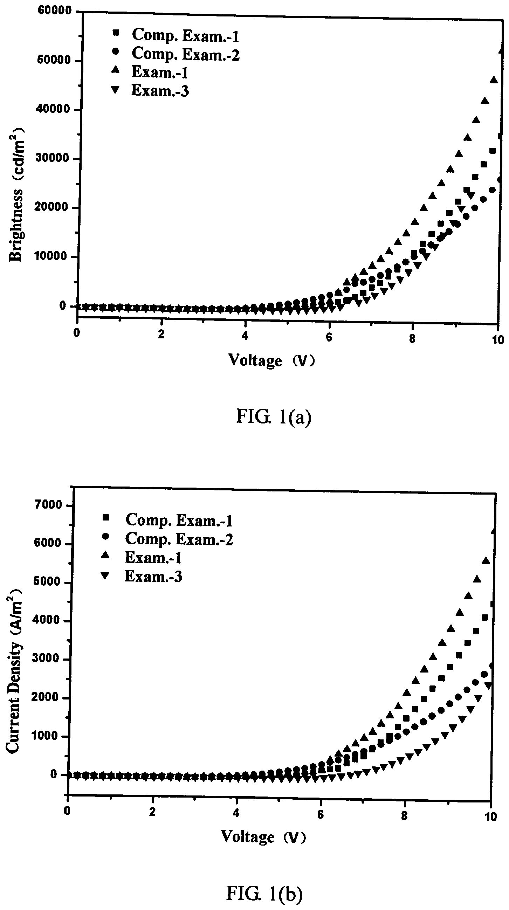

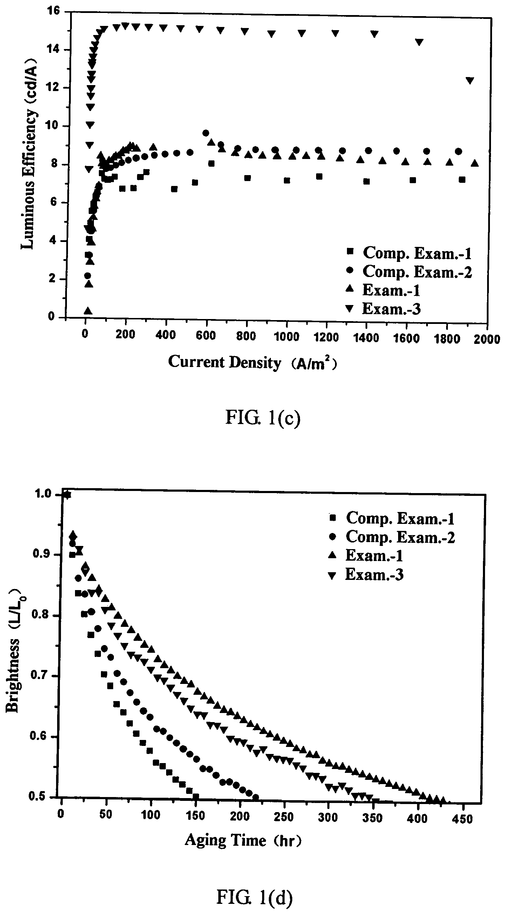

**FIG 1** is a graph showing the device characteristics of EXAMPLE 1-5 and COMPARATIVE EXAMPLE 1-2. **FIG 1(a)** is luminance as a function of driven voltage. **FIG 1(b)** is current density as a function of driven voltage. **FIG 1(c)** is luminous efficiency as a function of current density. **FIG 1(d)** is luminance as a function of aging time with initial brightness of 5000 cd/m².

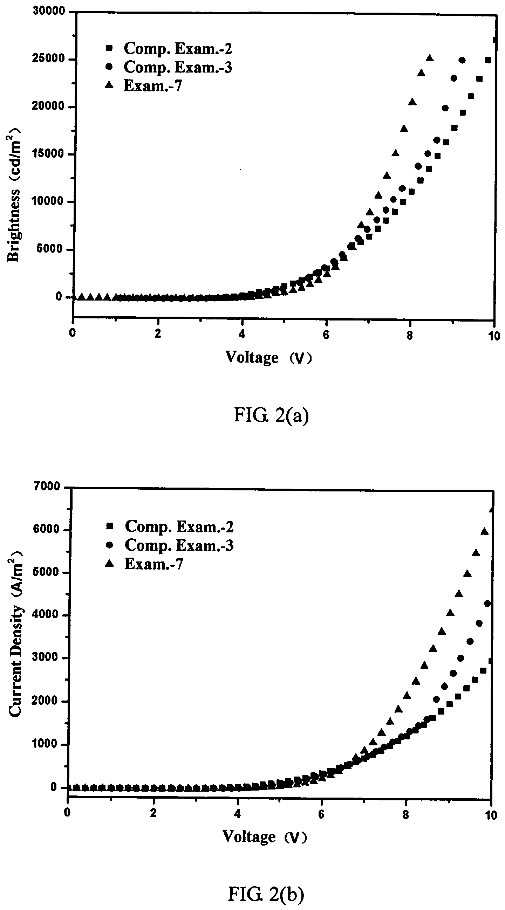

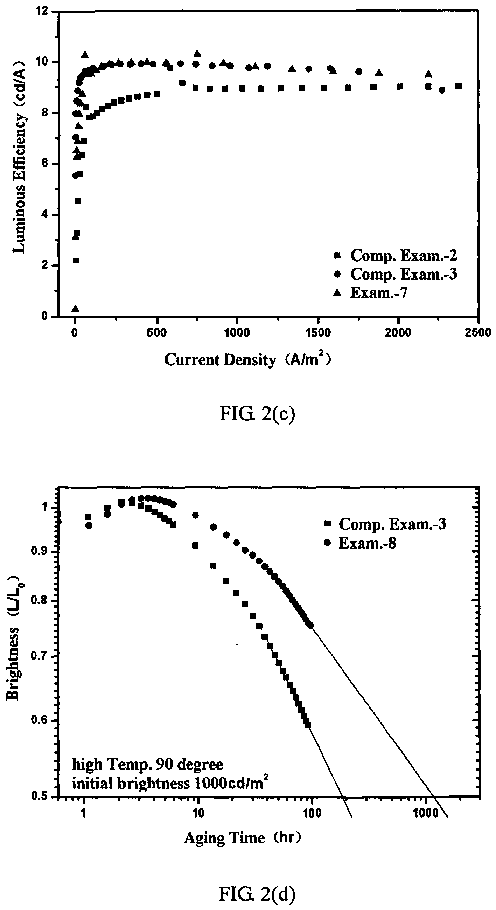

**FIG 2** is a graph showing the device characteristics of EXAMPLE 6-9 and COMPARATIVE EXAMPLE 2-3. **FIG 2(a)** is luminance as a function of driven voltage. **FIG 2(b)** is current density as a function of driven voltage. **FIG 2(c)** is luminous efficiency as a function of current density. **FIG 2(d)** is luminance as a function of aging time with initial brightness of 1000 cd/m² at high temperature of 90°C.

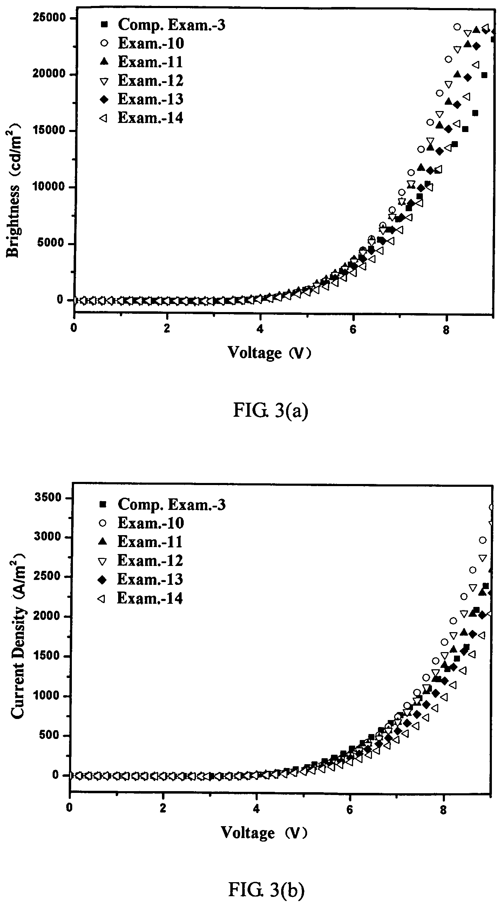

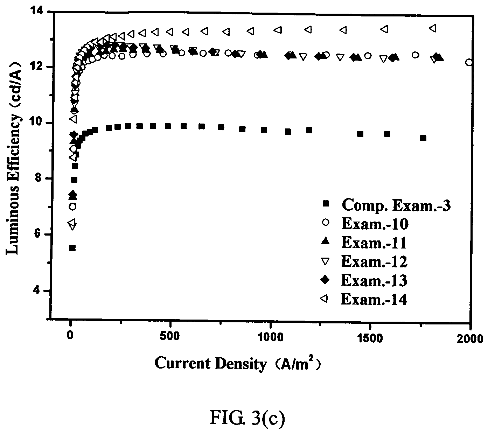

**FIG 3** is a graph showing the device characteristics of EXAMPLE 10-14 and COMPARATIVE EXAMPLE 3. **FIG 3(a)** is luminance as a function of driven voltage. **FIG 3(b)** is current density as a function of driven voltage. **FIG 3(c)** is luminous efficiency as a function of current density.

### DESCRIPTION OF THE PREFERRED EMBODIMENTS

According to some embodiments of the present invention, the basic structure of organic electroluminescent device includes: transparent substrate, which may be glass or flexible substrate. The flexible substrate may be one of polyester or polyimide compound. The first electrode (anode), which may be inorganic material or organic conductive polymer. The inorganic material is usually oxide of metal, such as indium tin oxide (ITO), zinc oxide and tin zinc oxide and so on, or metal with high work function, such as gold, copper and silver, etc. The optimization is ITO. The organic conductive polymer may be PEDOT:PSS, polyaniline. The second electrode (cathode), which may be metal with low work function, such as lithium, magnesium, calcium, strontium, aluminum, indium, etc. or alloy of them and copper, gold and silver, or alternate layers of metal and fluoride of metal. The optimization in present invention is MgAg alloy/Ag and LiF/Al.

The host of HIL may be CuPc, m-MTDATA and 2-TNATA.

The host of HTL may be aromatic amine derivatives, especially, NPB.

The materials of EML may be commonly selected from small molecules, such as fluorescent and phosphorescent materials. The fluorescence may be formed from metal complexes (such as Alq₃, Gaq₃, Al(Saph-q) or Ga(Saph-q)) and dyes (such as rubrene, DMQA, C545T, DCJTB or DCM). The concentration of dye in EML is 0.01%∼20% by weight. The phosphorescence is from carbazole derivatives (such as CBP) or polyethylene carbazole compound (such as PVK). The phosphorescent dyes may, for example, be Ir(ppy)₃, Ir(ppy)₂(acac), PtOEP, etc.

The materials used in ETL may be smal molecular capable of electron transporting, such as metal complexes (such as Alq₃, Gaq₃, Al(Saph-q) or Ga(Saph-q)), fused-ring aromatic compounds (such as pentacene, perylene), or phenanthroline compounds (such as Bphen, BCP), etc.

Now, the present invention will be illustrated in further detail with reference to the following Examples. However, it should be understood that the present invention is by no means restricted to such specific Examples.

### EXAMPLE 1 (Exam.-1)

### Device structure:

**Glass/ITO/m-MTDATA(120nm):BiF₃[40%]/NPB(30nm)/**
**Alq₃(30nm):C545T[1%]/Alq₃(20nm)/LiF(0.5nm)/Al(200nm)**

An organic electroluminescent device having the structure above is prepared by the following method.

The glass substrate is cleaned by thermal detergent ultrasonic and deionized water ultrasonic methods, and then dried under an infrared lamp. Then, the dried glass substrate is preprocessed by ultraviolet ozone cleaning and low energy oxygen ion beam bombardment, wherein the indium tin oxide (ITO) film on the substrate is used as an anode layer. The Sheet Resistance of the ITO film is 50 Ω, and its thickness is 150 nm.

The preprocessed glass substrate is placed in a vacuum chamber which is pumped to 1×10⁻⁵ Pa. A hole injection layer is deposited on the ITO anode by co-evaporating of m-MTDATA and BiF₃ from separated crucible at an evaporation rate of 0.1nm/s. The film thickness of the HIL is about 120nm and the concentration of BiF₃ is 40%.

A hole transport layer of NPB is deposited on the HIL without disrupting the vacuum. The evaporation rate of NPB is 0.2nm/s and the film thickness is 30nm.

Then, an emitting layer of Alq₃ doping with C545T is vapor-deposited onto the HTL by co-evaporation. The layer thickness is 20nm. The concentration of C545T is 1%.

The electron transport layer is Alq₃, which is deposited onto the emitting layer. The evaporation rate of Alq₃ is 0.2nm/s and the layer thickness is 20nm.

At last, LiF is vapor-deposited thereon as a electron injection layer in a thickness of 0.5nm and aluminum as a cathode in a thickness of 200nm with evaporation rate of 0.05nm/s and 2.0nm/s, respectively.

### EXAMPLE 2 (Exam.-2)

### Device structure:

**Glass/ITO/m-MTDATA(120nm): Bi₂O₃ [40%]/NPB(30nm)/**
**Alq₃(30nm):C545T[1%]/Alq₃(20nm)/LiF(0.5nm)/Al(200nm)**

A device is prepared in the same manner as in Example 1 except that the dopant material in HIL is changed to Bi₂O₃.

### EXAMPLE 3 (Exam.-3)

### Device structure:

**Glass/ITO/m-MTDATA(120nm): Sm₂(CO₃)₃** [**40%]/NPB(30nm)/**
**Alq₃**(**30nm**)**:C545T[1%]/Alq₃**(**20nm**)**/LiF**(**0**.**5nm**)**/Al**(**200nm**)

A device is prepared in the same manner as in Example 1 except that the dopant material in HIL is changed to Sm₂(CO₃)₃.

### EXAMPLE 4 (Exam.-4)

### Device structure:

**Glass/ITO/m-MTDATA(120nm): YbF₃** [**40%]/NPB**(**30nm**)**/**
**Alq₃**(**30nm**)**:C545T[1%]**/**Alq₃**(**20nm**)/**LiF**(**0**.**5nm**)/**Al**(**200nm**)

A device is prepared in the same manner as in Example 1 except that the dopant material in HIL is changed to YbF₃.

### EXAMPLE 5 (Exam.-5)

### Device structure:

**Glass**/**ITO**/**m-MTDATA(120nm): YbCl₃** [**40%]/NPB**(**30nm**)/
**Alq₃**(**30nm**)**:C545T[1%]/Alq₃**(**20nm**)/**LiF**(**0**.**5nm**)/**Al**(**200nm**)

A device is prepared in the same manner as in Example 1 except that the dopant material in HIL is changed to YbCl₃.

### COMPARATIVE EXAMPLE 1 (Comp. Exam.-1)

### Device structure:

**Glass/ITO/ m-MTDATA(120nm): WO₃** [**33%]/NPB**(**30nm**)/
**Alq₃(30nm):C545T[1%]/Alq₃(20nm)/LiF(0.5nm)/Al(200nm)**

A device is prepared in the same manner as in Example 1 except that the dopant material in HIL is changed to WO₃ and the concentration is 33%.

### COMPARATIVE EXAMPLE 2(Comp. Exam.-2)

### Device structure:

**Glass/ITO/ m-MTDATA(120nm)/NPB(30nm)/Alq₃(30nm):C545T[1%]/**
**Alq₃(20nm)/LiF(0.5nm)/Al(200nm)**

A device is prepared in the same manner as in Example 1 except that there is no dopant material in HIL

**Table 1: Performance comparison between devices of Exam. 1-5 and Comp. Exam. 1-2.**

| Device No. | HIL | Brightness (cd/m²@7V) | Current Density (A/m²@7V) | Luminous Efficiency (cd/A@7V) | Max. Efficiency (cd/A) |
|---|---|---|---|---|---|
| Exam.-1 | m-MTDATA(120 nm):BiF₃[40%] | 9333 | 1082 | 8.62 | 8.99 |
| Exam.-2 | m-MTDATA(120 nm): Bi₂O₃ [40%] | 6675 | 736 | 9.07 | 9.11 |
| Exam.-3 | m-MTDATA(120 nm): Sm₂(CO₃)₃ [40%] | 3452 | 226 | 15.27 | 15.42 |
| Exam.-4 | m-MTDATA(120 nm): YbF₃ [40%] | 5524 | 625 | 8.83 | 8.94 |
| Exam.-5 | m-MTDATA(120 nm): YbCl₃ [40%] | 5857 | 652 | 8.99 | 9.02 |
| Comp. Exam.-1 | m-MTDATA(120 nm): WO₃[33%] | 5000 | 612 | 8.17 | 8.21 |
| Comp. Exam.-2 | m-MTDATA(120 nm) | 6627 | 739 | 8.97 | 9.34 |

As shown in FIG. 1 and Table 1, the luminous efficiency of Exam.-1 and Exam.-3 are all improved compared to Comp.Exam.-1, particularly that of Exam.-3 is increased by nearly 1 times. However, the driven voltage of Exam.-3 is a little higher, which can be ascribed to the non-conductive characteristics of Sm₂(CO₃)₃. It is interesting that the better balance between hole and electron due to the insulating properties can lead to the improved luminous efficiency of the device. It is should note that the dopant of BiF₃ can improve the driven voltage and brightness and hence the luminous efficiency. FIG. 1(d) is a graph of half-lifetime of the four devices at an initial brightness of 5000cd/m². Exam.-1 have a long half-lifetime of about 420hr, compared to 150hr of Comp. Exam.-1, improved by 1.8 times. The doping of inorganic inactive material in HIL can obviously facilitate the stability of devices.

### EXAMPLE 6 (Exam.-6)

### Device structure:

**Glass/ITO/ m-MTDATA(120nm): YbCl₃ [50%]:F₄-TCNQ[2%]/NPB(30nm)/**
**Alq3(30nm):C545T[1%]/Alq3(20nm)/LiF(0.5nm)/Al(200nm)**

A device is prepared in the same manner as in Example 1 except that the dopant material in HIL is changed to YbCl₃ and F₄-TCNQ and the concentration of F₄-TCNQ **in HIL is 2%.**

### EXAMPLE 7 (Exam.-7)

### Device structure:

**Glass/ITO/ m-MTDATA(120nm): Bi₂O₃ [50%]:F₄-TCNQ[2%]/NPB(30nm)/**
**Alq₃(30nm):C545T[1%]/Alq₃(20nm)/LiF(0.5nm)/Al(200nm)**

A device is prepared in the same manner as in Example 6 except that the dopant material of YbCl₃ in HIL is changed to Bi₂O₃ and the concentration of Bi₂O₃ in HIL is 50wt%.

### EXAMPLE 8 (Exam.-8)

### Device structure:

**Glass/ITO/ m-MTDATA(120nm):F₄-TCNQ[2%]/**
**NPB(10nm)/NPB(5nm): Bi₂O₃[20%]/NPB(10nm)/**
**Alq₃(30nm):C545T[1%]/Alq₃(20nm)/LiF(0.5nm)/Al(200nm)**

A device is prepared in the same manner as in Example 1 except that the dopant material of in HIL is changed to F₄-TCNQ and the concentration of F₄-TCNQ in HIL is 2wt%.

The HTL of the device is firstly evaporated a 10nm thick NPB layer, and then co-evaporated NPB and Bi₂O₃. The doping layer thickness is 5nm and the concentration of Bi₂O₃ in the doping layer is 20wt%. At last, a NPB layer of 10nm thick is deposited onto the doping layer.

### EXAMPLE 9 (Exam.-9)

### Device structure:

**Glass/ITO/ m-MTDATA(200nm): BiF₃ [50%]:F₄-TCNQ[2%]**
**/NPB(10nm)/NPB(15nm): YbCl₃ [30%]/NPB(10nm)/**
**Alq₃(30nm):C545T[1%]/Alq₃(20nm)/LiF(0.5nm)/Al(200nm)**

A device is prepared in the same manner as in Example 7 except that the dopant material of Bi₂O₃ in HIL is changed to BiF₃ and the total thickness of doping film is 200nm.

The HTL of the device is firstly evaporated a 10nm thick NPB layer, and then co-evaporated NPB and YbCl₃. The doping layer thickness is 15nm and the concentration of YbCl₃ in the doping layer is 30wt%. At last, a NPB layer of 10nm thick is deposited onto the doping layer.

### COMPARATIVE EXAMPLE 3 (Comp. Exam.-3)

### Device structure:

**Glass/ITO/ m-MTDATA(120nm): F₄-TCNQ [2%]/NPB(30nm)/**
**Alq₃(30nm):C545T[1%]/Alq₃(20nm)/LiF(0.5nm)/Al(200nm)**

A device is prepared in the same manner as in Example 1 except that the dopant material in HIL is changed to F₄-TCNQ and the concentration of F₄-TCNQ is 2%.

**Table 2: Performance comparison between devices of Exam.6-9 and Comp. Exam. 2-3.**

| Device No. | HIL | HTL | Brightness (cd/m²@7V) | Current Density (A/m²@7V) | Luminous Efficiency (cd/A@7V) | Max. Efficiency (cd/A) |
|---|---|---|---|---|---|---|
| Exam-6 | m-MTDATA (120nm): YbCl3 [50%] : F₄-TCNQ [2%] | NPB(30nm) | 8512 | 774 | 10.99 | 11.56 |
| Exam-7 | m-MTDATA (120nm): Bi₂O₃ [50%]:F₄-TCNQ [2%] | NPB(30nm) | 9100 | 916 | 9.94 | 10.73 |
| Exam-8 | m-MTDATA (120nm):F4-TCNQ [2%] | NPB(10nm)/ NPB(5nm): Bi₂O₃ (20%)/NPB(10nm ) | 9013 | 920 | 9.79 | 10.02 |
| Exam-9 | m-MTDATA (200nm): BiF₃ [50%]:F₄-TCNQ [2%] | NPB(10nm)/ NPB(15nm): YbCl₃ [30%]/NPB (10nm) | 9056 | 917 | 9.87 | 10.15 |
| Comp. Exam-2 | m-MTDATA (120nm) | NPB(30nm) | 6627 | 739 | 8.97 | 9.34 |
| Comp. Exam-3 | m-MTDATA (120nm): F₄-TCNQ[2%] | NPB(30nm) | 7343 | 743 | 9.88 | 9.91 |

The both doping of inorganic inactive material and F₄-TCNQ can improve the device voltage effectively as listed on Table 2 and depicted in FIG. 2. There are obvious improvements of driven voltage and luminous efficiency in Exam.-7, compared to Comp. Exam.-2 without doping. Comparing with Comp. Exam.-3, Exam.-7 also have an improvement of driven voltage and the same efficiency. It shows that the doping of two kinds of different materials (such as, inorganic inactive material and F₄-TCNQ) can reduce hole injection barrier and decrease driven voltage besides the balance of charge carrier.

FiG. 2(d) is a graph of brightness as function of aging time of Exam.-8 and Comp. Exam.-3. Both devices are tested at a high temperature of 90°C and the initial brightness is about 1000cd/m². It is obvious that there is 4 times of improvement in Exam.-8, which demonstrated that the thermal stability of the doping device have been improved largely due to the high stable material of Bi₂O₃.

### EXAMPLE 10 (Exam.-10∼Exam.-14)

### Device structure:

**Glass/ITO/2-TNATA (120nm): BiF₃ [x%]:F₄**-**TCNQ[2%]/NPB**(**30nm**)**/**
**Alq₃(30nm):C545T[1%]/Alq₃(20nm)/LiF(0.5nm)/Al(200nm)**

A device is prepared in the same manner as in Example 1 except that the host material in HIL is changed to 2-TNANA and the dopant material changed to BiF₃ and F₄-TCNQ. The concentration of F₄-TCNQ in HIL is 2% and that of BiF₃ is x, where x is 4, 10, 20, 40, 50, respectively.

**Table 3: Performance comparison between devices of Exam.10-14 and Comp. Exam.-3.**

| Device No. | HIL | Brightness (cd/m²@7V) | Current Density (A/m²@7V) | Luminous Efficiency (cd/A@7V) | Max. Efficiency (cd/A) |
|---|---|---|---|---|---|
| Exam-10 | 2-TNATA(120nm): BiF₃ [4%]:F₄-TCNQ[2%] | 9732 | 775 | 12.56 | 12.62 |
| Exam-11 | 2-TNATA (120nm): BiF₃ [10%]:F₄-TCNQ[2%] | 9583 | 764 | 12.54 | 12.66 |
| Exam-12 | 2-TNATA (120nm): BiF₃ [20%]:F₄-TCNQ[2%] | 8955 | 711 | 12.59 | 12.87 |
| Exam-13 | 2-TNATA (120nm): BiF₃ [40%]:F₄-TCNQ[2%] | 8117 | 644 | 12.60 | 12.82 |
| Exam-14 | 2-TNATA (120nm): BiF₃ [50%]:F₄-TCNQ[2%] | 6952 | 523 | 13.28 | 13.55 |
| Comp. Exam-3 | m-MTDATA(120nm): F₄-TCNQ[2%] | 7343 | 743 | 9.88 | 9.91 |

The luminous efficiencies of all the devices doped with BiF₃ are higher than Comp. Exam.-3 obviously, as shown in Table 3 and FIG. 3. The improvement of efficiency can be ascribed to the better balance of charge carrier in the emissive zone due to BiF₃ doping. As the doping concentration of BiF₃ increased, the driven voltage in devices increase and brightness decrease. The device performance is inferior to Comp. Exam.-3 when doping concentration of BiF₃ is more over 20%.

### EXAMPLE 15 (Exam.-15)

### Device structure:

**Glass/ITO/2-TNATA(80nm):Sm₂(CO₃)₃[12%]:WO₃[17%]/2-TNATA(20nm)/ NPB**(**10nm**)/**NPB**(**5nm**)**:NdF₃**[**50%]**/**NPB**(**10nm**)**/**
**Alq₃(30nm):C545T[1%]/Alq₃(20nm)/LiF(0.5nm)/Al(200nm)**

A device is prepared in the same manner of EML, ETL, EIL and cathode as in Example 1 except that the HIL and HTL.

The HIL of the device is firstly co-evaporated by 2-TNATA, Sm₂(CO₃)₃ and WO₃ from separated crucible. The concentration of Sm₂(CO₃)₃ and WO₃ is 12wt% and 17wt%, respectively. The film thickness is 80nm. Then, a 20nm thick layer of 2-TNATA is deposited on the top of the doping layer.

The HTL of the device is firstly evaporated a 10nm thick NPB layer, and then co-evaporated NPB and NdF₃. The doping layer thickness is 5nm and the concentration of NdF₃ in doping layer is 50%. At last, a NPB layer of 10nm thick is deposited onto the doping layer.

### EXAMPLE 16 (Exam.-16)

### Device structure:

**Glass/ITO/m-MTDATA(100nm):WO₃[20%]/2-TNATA(50nm):PrF₃[30%]/N PB(30nm)/**
**Alq₃(30nm):C545T[1%]/Alq₃(20nm)/LiF(0.5nm)/Al(200nm)**

A device is prepared in the same manner as in Example 1 except that the HIL

The HIL of the device is made of two layers. One is co-evaporated by m-MTDATA and WO₃ onto the ITO anode. This layer is 100nm thick and then concentration of WO₃ is 20%. The other layer is also co-evaporated by 2-TNATA and PrF₃ on the top of first layer. The layer thickness is 50nm and the concentration of PrF₃ is 30%.

### EXAMPLE 17 (Exam.-17)

### Device structure:

**Glass/ITO/m-MTDATA(40nm):F₄-TCNQ[2%]/**
**m-MTDATA(30nm):Ho₂(CO₃)₃[80%]/m-MTDATA(40nm):F₄-TCNQ[2%]/**
**NPB(30nm)/Alq₃(30nm):C545T[1%]/Alq₃(20nm)/LiF(0.5nm)/Al(200nm)**

A device is prepared in the same manner as in Example 1 except that the HIL

The HIL of the device is made of three layers. The first one is co-evaporated by m-MTDATA and F₄-TCNQ onto the ITO anode. This layer is 40nm thick and the concentration of F₄-TCNQ is 2%. The second layer is also co-evaporated by m-MTDATA and Ho₂(CO₃)₃ on the top of first layer. The layer thickness is 30nm and the concentration of Ho₂(CO₃)₃ is 80%. The third layer is the same as the first layer.

### EXAMPLE 18 (Exam.-18)

### Device structure:

**Glass/ITO/2-TNATA(10nm):Nd₂O₃[4%]/2-TNATA(100nm):V₂O₅[10%]/**
**NPB(15nm):NdF₃[50%]/NPB(15nm)/**
**Alq₃(30nm):C545T[1%]/Alq3(20nm)/LiF(0.5nm)/Al(200nm)**

A device is prepared in the same manner as in Example 1 except that the HIL and HTL.

The HIL of the device is made of two layers. The first one is co-evaporated by 2-TNATA and Nd₂O₃ onto the ITO anode. This layer is 10nm thick and the concentration of Nd₂O₃ is 4%. The second layer is also co-evaporated by 2-TNATA and V₂O₅ on the top of first layer. The layer thickness is 100nm and the concentration of V₂O₅ is 10%.

The HTL of the device is firstly evaporated a 15nm thick co-evaporation layer of NPB and NdF₃. The concentration of NdF₃ in doping layer is 50%. At last, a NPB layer of 15nm thick is deposited onto the doping layer.

**Table 4: Performance comparison between devices of Exam.15-18 and Comp. Exam.-3.**

| Device No. | HIL | HTL | Brightness (cd/m²@7V) | Current Density (A/m²@7V) | Luminous Efficiency (cd/A@7V) | Max. Efficiency (cd/A) |
|---|---|---|---|---|---|---|
| Exam-15 | 2-TNATA(80nm): Sm₂(CO₃)₃ [12%]:WO₃[17%]/2-TNATA (20nm) | NPB(10nm)/ NPB(5nm): NdF₃[50%]/ NPB (10nm) | 5728 | 587 | 9.75 | 9.96 |
| Exam-16 | m-MTDATA(100nm):WO₃ [20%]/2-TNATA(50nm): PrF₃[30%] | NPB(30nm) | 8523 | 873 | 9.76 | 10.32 |
| Exam-17 | m-MTDATA(40nm):F₄-TCNQ [2%]/m-MTDATA(30nm): Ho₂(CO₃)₃[80%]/m-MTDATA (40nm):F₄-TCNQ[2%] | NPB(30nm) | 7168 | 697 | 10.28 | 10.89 |
| Exam-18 | 2-TNATA(10nm):Nd₂O₃[4%]/ 2-TNATA(100nm):V₂O₅[10%] | NPB(15nm): NdF₃ [50%]/ NPB (15nm) | 9013 | 816 | 11.05 | 12.86 |
| Comp. Exam-3 | m-MTDATA(120nm): F₄-TCNQ[2%] | NPB(30nm) | 7343 | 743 | 9.88 | 9.91 |

The doping position of dopant materials in HIL and HTL is adjusted in Exam.-15∼Exam.-18. From the data listed on Table 4, these doping devices have similar performance compared to Comp. Exam.-3, more particularly, Exam.-18 have the best characteristics. The control of concentration of hole and electron zonely by change the doping position can facilitate the balance of charge carrier and reach an excellent performance.

### EXAMPLE 19 (Exam.-19)

### Device structure:

**Glass/ITO/2-TNATA(10nm):Nd₂O₃[4%]/2-TNATA(100nm):V₂O₅[10%]/**
**NPB(15nm):NdF₃[50%]/NPB(15nm)/Alq₃(30nm):C545T[1%]/**
**Alq₃**(**10nm**)/**Alq₃**(**10nm**)**:BiF₃**[**20%]/LiF**(**0**.**5nm**)/**Al**(**200nm**)

A device is prepared in the same manner as in Example 18 except that the ETL.

The ETL of the device is a 10nm thick Alq₃ layer and a 10nm thick doping layer of Alq₃ and BiF₃. The concentration of BiF₃ in doping layer is 20wt%.

### EXAMPLE 20 (Exam.-20)

### Device structure:

**Glass/ITO/m-MTDATA(120nm):F₄-TCNQ[2%]/NPB(30nm)/Alq₃(30nm):C5 45T[1%]/**
**Alq₃(5nm)/Alq₃(20nm):Bi₂O₃[10%]/LiF(0.5nm)/Al(200nm)**

A device is prepared in the same manner as in Comparative Example 3 except that the ETL.

The ETL of the device is a 5nm thick Alq₃ layer and a 20nm thick doping layer of Alq₃ and Bi₂O₃. The concentration of Bi₂O₃ in doping layer is 10wt%.

**Table 5: Performance comparison between devices of Exam. 19-20 and Comp. Exam.2-3.**

| Device No. | HIL | HTL | ETL | Brightness (cd/m²@7V) | Current Density (A/m²@7V) | Luminous Efficiency (cd/A@7V) | Max. Efficiency (cd/A) |
|---|---|---|---|---|---|---|---|
| Exam-19 | 2-TNATA(10nm): Nd₂O₃[4%]/2-TNATA (100nm): V₂O₅[10%] | NPB(15nm): NdF₃[50%]/NPB (15nm) | Alq₃(10nm)/ BiF₃ [20%] | 8120 | 736 | 11.03 | 11.51 |
| Exam-20 | m-MTDATA(120nm): F₄-TCNQ[2%] | NPB(30nm) | Alq₃(5nm)/ Alq₃ (20nm): Bi₂O₃ [10%] | 7506 | 778 | 9.65 | 9.89 |
| Comp. Exam-2 | m-MTDATA(120nm) | NPB(30nm) | Alq₃(20nm) | 6627 | 739 | 8.97 | 9.34 |
| Comp. Exam-3 | m-MTDATA(120nm): F₄-TCNQ[2%] | NPB(30nm) | Alq₃(20nm) | 7343 | 743 | 9.88 | 9.91 |

The doping of inorganic materials in HIL, HTL and ETL have been applied in Exam.-19 and Exam.-20. Comparing with Comp. Exam.-2 and Comp. Exam.-3, Exam.-19 has a better performance and Exam.-20 is similar to Comp. Exam.-3. The doping of inorganic inactive materials in HIL, HTL and ETL simultaneity can favor the balance of hole and electron and get an expected device.

## Claims

1. An organic electroluminescent device comprising
an anode;
a cathode; and
an organic functional layer between the anode and the cathode;
wherein the organic functional layer comprises light emission layer and at least one of hole injection layer and hole transport layer, the at least one of hole injection layer and hole transport layer comprises a host material and an inorganic inactive material doped in the host material, and the inorganic inactive material doped in the host material is a halide, sulfide, carbide, nitride or carbonate of a metal of lanthanide series of the Periodic Table, or halide, sulfide, carbide, nitride or carbonate of bismuth.

2. The organic electroluminescent device according to claim 1, wherein the inorganic inactive material is doped in the whole host material uniformly.

3. The organic electroluminescent device according to claim 1, wherein the inorganic inactive material is doped in the partial or whole host material in a gradient manner.

4. The organic electroluminescent device according to claim 1, wherein the inorganic inactive material is doped in at least one zone of the host material.

5. The organic electroluminescent device according to claim 4, wherein the number of said zones is 1∼5.

6. The organic electroluminescent device according to claim 1, wherein the concentration of said inorganic inactive material in the host material is 1∼99 wt%.

7. The organic electroluminescent device according to claim 1, wherein the halide, oxide, sulfide, carbide, nitride or carbonate of metal of lanthanide series is a halide, oxide, sulfide, carbide, nitride or carbonate of neodynium, samarium, prascodymium or holmium.

8. The organic electroluminescent device according to any one of claims 1-6, wherein the inorganic inactive material is selected from BiF₃, BiCl₃, BiBr₃, BiI₃, YbF₃, YbF_{2;} YbCl₃, YbCl₂, YbBr₃, YbBr-2, Yb₂O₃, Yb₂(CO₃)₃, and mixtures thereof.

9. The organic electroluminescent device according to any one of claims 1-8, wherein the inorganic inactive material is BiF₃ or YbF₃, and the concentration of the inorganic inactive material in the host material is 30∼40 wt%.

10. The organic electroluminescent device according to any one of claims 1-9, wherein the inorganic inactive material doped in the host material has a thickness of 10∼200 nm in the hole injection layer.

11. The organic electroluminescent device according to any one of claims 1-9, wherein the inorganic inactive material doped in the host material has a thickness of 5∼20 nm in the hole transport layer.

12. The organic electroluminescent device according to any one of claims 1-11, wherein in the hole injection layer, the host material is CuPc, m-MTDATA or 2-TNATA.

13. The organic electroluminescent device according to any one of claims 1-12, wherein in the hole transport layer, the host material is TPD, NPB, m-MTDATA, TCTA or spiro-NPB.

14. A method for preparing the organic electroluminescent device according to any one of claims 1-13, comprising doping the inorganic inactive material into the host material of at least one of hole injection layer and hole transport layer.

## Patentansprüche

1. Organische Elektrolumineszenzvorrichtung, die Folgendes umfasst:
eine Anode;
eine Kathode; und
eine organische funktionelle Schicht zwischen der Anode und der Kathode;
wobei die organische funktionelle Schicht eine Lichtemissionsschicht und mindestens eine von einer Lochinjektionsschicht und einer Lochtransportschicht umfasst, wobei die mindestens eine von einer Lochinjektionsschicht und einer Lochtransportschicht ein Wirtsmaterial und ein anorganisches inaktives Material, das in dem Wirtsmaterial dotiert ist, umfasst, und das anorganische inaktive Material, das in dem Wirtsmaterial dotiert ist, ein Halogenid, Sulfid, Carbid, Nitrid oder Carbonat eines Metalls der Lanthanidreihe des Periodensystems der Elemente oder ein Halogenid, Sulfid, Carbid, Nitrid oder Carbonat von Bismut ist.

2. Organische Elektrolumineszenzvorrichtung nach Anspruch 1, wobei das anorganische inaktive Material in dem gesamten Wirtsmaterial einheitlich dotiert ist.

3. Organische Elektrolumineszenzvorrichtung nach Anspruch 1, wobei das anorganische inaktive Material in dem partiellen oder gesamten Wirtsmaterial auf Gradientenweise dotiert ist.

4. Organische Elektrolumineszenzvorrichtung nach Anspruch 1, wobei das anorganische inaktive Material in mindestens einer Zone des Wirtsmaterials dotiert ist.

5. Organische Elektrolumineszenzvorrichtung nach Anspruch 4, wobei die Anzahl der besagten Zonen 1-5 ist.

6. Organische Elektrolumineszenzvorrichtung nach Anspruch 1, wobei die Konzentration des besagten anorganischen inaktiven Materials in dem Wirtsmaterial 1-99 Gew.-% ist.

7. Organische Elektrolumineszenzvorrichtung nach Anspruch 1, wobei das Halogenid, Oxid, Sulfid, Carbid, Nitrid oder Carbonat eines Metalls der Lanthanidreihe ein Halogenid, Oxid, Sulfid, Carbid, Nitrid oder Carbonat eines Metalls der Lanthanidreihe von Neodym, Samarium, Praseodym oder Holmium ist.

8. Organische Elektrolumineszenzvorrichtung nach einem der Ansprüche 1-6, wobei das anorganische inaktive Material aus BiF₃, BiCl₃, BiBr₃, BiI₃, YbF₃, YbF₂, YbCl₃, YbCl₂, YbBr₃, YbBr₂, Yb₂O₃, Yb₂(CO₃)₃ und Gemischen davon ausgewählt ist.

9. Organische Elektrolumineszenzvorrichtung nach einem der Ansprüche 1-8, wobei das anorganische inaktive Material BiF₃ oder YbF₃ ist und die Konzentration des anorganischen inaktiven Materials in dem Wirtsmaterial 30-40 Gew.-% ist.

10. Organische Elektrolumineszenzvorrichtung nach einem der Ansprüche 1-9, wobei das anorganische inaktive Material, das in dem Wirtsmaterial dotiert ist, eine Dicke von 10-200 nm in der Lochinjektionsschicht aufweist.

11. Organische Elektrolumineszenzvorrichtung nach einem der Ansprüche 1-9, wobei das anorganische inaktive Material, das in dem Wirtsmaterial dotiert ist, eine Dicke von 5-20 nm in der Lochtransportschicht aufweist.

12. Organische Elektrolumineszenzvorrichtung nach einem der Ansprüche 1-11, wobei das Wirtsmaterial in der Lochinjektionsschicht CuPc, m-MTDATA oder 2-TNATA ist.

13. Organische Elektrolumineszenzvorrichtung nach einem der Ansprüche 1-12, wobei das Wirtsmaterial in der Lochtransportschicht TPD, NPB, m-MTDATA, TCTA oder Spiro-NPB ist.

14. Verfahren zur Herstellung der organischen Elektrolumineszenzvorrichtung nach einem der Ansprüche 1-13, wobei das Verfahren das Dotieren des anorganischen inaktiven Materials in das Wirtsmaterial von mindestens einer von einer Lochinjektionsschicht und einer Lochtransportschicht umfasst.

## Revendications

1. Dispositif électroluminescent organique comprenant
une anode ;
une cathode ; et
une couche organique fonctionnelle entre l'anode et la cathode ;
dans lequel la couche organique fonctionnelle comprend une couche émettrice de lumière et au moins une couche parmi une couche d'injection de trous et une couche de transport de trous, la au moins une couche parmi une couche d'injection de trous et une couche de transport de trous comprend un matériau hôte et un matériau inorganique inactif dopé dans le matériau hôte, et le matériau inorganique inactif dopé dans le matériau hôte est un halogénure, un sulfure, un carbure, un nitrure ou un carbonate d'un métal de la série des lanthanides du tableau périodique, ou un halogénure, un sulfure, un carbure, un nitrure ou un carbonate de bismuth.

2. Dispositif électroluminescent organique selon la revendication 1, dans lequel le matériau inorganique inactif est dopé uniformément dans la totalité du matériau hôte.

3. Dispositif électroluminescent organique selon la revendication 1, dans lequel le matériau inorganique inactif est dopé dans une partie ou la totalité du matériau hôte selon un gradient.

4. Dispositif électroluminescent organique selon la revendication 1, dans lequel le matériau inorganique inactif est dopé dans au moins une zone du matériau hôte.

5. Dispositif électroluminescent organique selon la revendication 4, dans lequel le nombre desdites zones est de 1∼5.

6. Dispositif électroluminescent organique selon la revendication 1, dans lequel la concentration dudit matériau inorganique inactif dans le matériau hôte est de 1-99 % en poids.

7. Dispositif électroluminescent organique selon la revendication 1, dans lequel l'halogénure, l'oxyde, le sulfure, le carbure, le nitrure ou le carbonate de métal de la série des lanthanides est un halogénure, un oxyde, un sulfure, un carbure, un nitrure ou un carbonate de néodyme, de samarium, de praséodyme ou d'holmium.

8. Dispositif électroluminescent organique selon l'une quelconque des revendications 1-6, dans lequel le matériau inorganique inactif est sélectionné parmi BiF₃, BiCl₃, BiBr₃, BiI₃, YbF₃, YbF₂, YbCl₃, YbCl₂, YbBr₃, YbBr₂, Yb₂O₃, Yb₂(CO₃)₃, et leurs mélanges.

9. Dispositif électroluminescent organique selon l'une quelconque des revendications 1-8, dans lequel le matériau inorganique inactif est BiF₃ ou YbF₃, et la concentration du matériau inorganique inactif dans le matériau hôte est de 30-40 % en poids.

10. Dispositif électroluminescent organique selon l'une quelconque des revendications 1-9, dans lequel le matériau inorganique inactif dopé dans le matériau hôte présente une épaisseur de 10-200 nm dans la couche d'injection de trous.

11. Dispositif électroluminescent organique selon l'une quelconque des revendications 1-9, dans lequel le matériau inorganique inactif dopé dans le matériau hôte présente une épaisseur de 5-20 nm dans la couche de transport de trous.

12. Dispositif électroluminescent organique selon l'une quelconque des revendications 1-11, dans lequel, dans la couche d'injection de trous, le matériau hôte est CuPc, m-MTDATA ou 2-TNATA.

13. Dispositif électroluminescent organique selon l'une quelconque des revendications 1-12, dans lequel, dans la couche de transport de trous, le matériau hôte est TPD, NPB, m-MTDATA, TCTA ou spiro-NPB.

14. Procédé de préparation du dispositif électroluminescent organique selon l'une quelconque des revendications 1-13, comprenant le dopage du matériau inorganique inactif dans le matériau hôte d'au moins une couche parmi une couche d'injection de trous et une couche de transport de trous.
